# EUROPÄISCHE PATENTSCHRIFT

(11) **EP 2 844 690 B1**
(45) Veröffentlichungstag und Bekanntmachung des Hinweises auf die Patenterteilung: **20.07.2016**
(21) Anmeldenummer: 13716260.8
(22) Anmeldetag: 05.04.2013
(51) Int. Cl.: C08K 3/00, C09J 7/00, C08K 7/02, C08K 9/04, C08K 13/04, C08K 9/02, C09J 9/02, C09J 11/04

(54) **DREIDIMENSIONAL ELEKTRISCH LEITFÄHIGE KLEBSTOFFFOLIE**
TRIDIMENSIIONAL ELECTROCONDUCTIVE ADHESIVE SHEET
FEUILLE ADHÉSIVE ÉLECTROCONDUCTICE TRIDIMENSIONNELLE

(30) Priorität: 04.05.2012 DE 102012207462
(43) Veröffentlichungstag der Anmeldung: 11.03.2015
(73) Patentinhaber: tesa SE, 22848 Norderstedt (DE)
(72) Erfinder: SCHERF, Lesmona, 20359 Hamburg (DE); KRAWINKEL, Thorsten, 22457 Hamburg (DE); FISCHER, Alexander, 20259 Hamburg (DE)
(86) Internationale Anmeldenummer: PCT/EP2013/057233
(87) Internationale Veröffentlichungsnummer: WO 2013/164154

(56) Entgegenhaltungen:
- WO-A1-00/01782
- WO-A2-2008/146014

## Beschreibung

Die Erfindung beschreibt eine in drei Dimensionen elektrisch leitfähige Klebefolie für die dauerhafte Verklebung zweier Gegenstände.

Da elektronische Bauteile immer kleiner und damit ihre Verarbeitbarkeit erschwert werden, ist ein Löten dieser Teile häufig nicht mehr einfach und kostengünstig möglich. Daher hat die Verklebung elektrischer und elektronischer Bauteile durch elektrisch leitende Klebstoffschichten an Bedeutung gewonnen. Zu diesem Zweck werden leitfähige Pigmente wie Russ, Metallpulver, ionische Verbindungen und ähnliche in Klebmassen eingesetzt. Es sind eine Reihe von Klebebändern auf dem Markt vorhanden, die entweder nur in z-Richtung, also durch das Klebeband hindurch oder sowohl in z- als auch in x und y-Richtung, also in der Ebene des Klebebandes leiten. Es gibt eine Reihe von unterschiedlichen Möglichkeiten diese Leitfähigkeit zu erreichen.
Eine Möglichkeit ist, einen leitfähigen Träger zu verwenden, so dass die Klebmasse nur in z-Richtung leitend sein muss, obwohl das gesamte Klebeband auch in x,y-Richtung leitend ist. Der Strom wird durch die Klebmasse zum Träger geleitet, wird dann in x,y-Richtung verteilt und wieder in z-Richtung durch die Klebmasse zur Oberfläche geleitet.

Schwieriger ist es, eine Leitfähigkeit in x,y-Richtung ohne einen Träger, also mit einem sogenannten Transfer-Klebeband, zu erhalten.

In einigen Bereichen insbesondere der Elektronikindustrie müssen sehr hohe Klebkräfte bei dünnen Schichtdicken der Klebebänder erzielt werden. In solchen Fällen, wie z.B. bei der Verklebung flexibler Leiterbahnen werden deshalb häufig trägerlose Klebebänder verwendet, da durch einen eventuellen Träger die Klebmasseschicht für eine sehr gute Verklebungsfestigkeit zu dünn wäre. Da bei diesen Anwendungen die Klebebänder auch sehr hohen Temperaturen ausgesetzt sind, z.B. bis zu 288 °C beim Lötkontaktieren der Bauteile, wären auch nur eine kleine Anzahl an Trägern überhaupt einsetzbar ohne zu schmelzen.

Beispiele für Transfer-Klebebänder, die nur in z-Richtung leiten sind aus der Literatur bekannt. Die US 3,475,213 beschreibt z.B. statistisch verteilte sphärische Partikel, die ganz aus einem leitfähigen Metall bestehen oder mit einer elektrisch leitenden Metallschicht überzogen sind. Die Partikel sind etwas kleiner als die Klebmasseschichten. In der US 4,113,981 sind Klebebänder beschrieben, die elektrisch leitende sphärische Partikel enthalten, die etwa die gleiche Größe wie die Dicke des Klebebandes besitzen und in einem Verhältnis von maximal 30 Vol % in der Klebmasse vorhanden sind. Weitere besondere Ausführungsformen und Anwendungen sind z.B. in der US 4,606,962 oder der US 5,300,340 beschrieben. Zudem muss bei der Verwendung von sphärischen Teilchen, um eine Leitfähigkeit auch in x- und y-Richtung zu erhalten, eine sehr große Menge an Teilchen eingesetzt werden, da diese sich berühren müssen.
Alle dieser beschriebenen Klebebänder basieren auf selbstklebenden oder hitzeaktivierbaren Acrylatklebmassen, die haftklebrig sind und dadurch zwei Substrate nicht mit einer Festigkeit verbinden können, wie dieses für viele Anwendungen nötig ist. Vor allem Verbindungen, die einer hohen Belastung durch Zug, Scherung oder Torsion ausgesetzt sind, zeigen nach kurzer Zeit Ablöseerscheinungen.

Durch den Zusatz von elektrisch leitenden Partikeln in einer Größenordnung von bis zu 30 Vol.-% wird die generell niedrige Klebkraft dieser Haftklebstoffe noch weiter abgesenkt. Die Verklebungsfestigkeiten sind nicht ausreichend, um dauerhafte Verbindungen bei mechanisch beanspruchten elektronischen Kontakten zu gewährleisten.

Da die Partikel zu einem gewissen Anteil aus der Oberfläche herausragen, besonders wenn hohe Leitfähigkeiten gefordert werden, dienen die Partikel als Abstandshalter zwischen der Klebmasse und dem zu verklebenden Substrat, wodurch die Verklebungsleistung weiter herabgesetzt wird.

Die beschriebenen Verfahren haben den weiteren Nachteil, dass sich die Verklebungen wieder lösen lassen, wodurch Manipulationen möglich sind.

Besonders flexible Bauteile wie flexible Leiterbahnen sind großen Biegebeanspruchungen unterlegen und sind besonders anfällig für ein adhäsives Versagen.

In der DE 199 12 628 A ist ein Klebeband auf Basis eines thermoplastischen Polymers beschrieben, das mit klebrigmachenden Harzen und Epoxidharzen abgemischt ist, die in der Hitze für eine Vernetzung sorgen. Als leitfähige Partikel sind ausschließlich Silberpartikel oder versilberte Glaskugeln genannt. Dieses beschriebene Klebeband besitzt aber nur eine Leitfähigkeit in z-Richtung, d.h. senkrecht zur Klebmasseschicht.

Eine in drei Dimensionen leitfähige Klebfolie lässt sich mit kugeligen Teilchen nur sehr schwer erreichen, da man eine sehr große Menge an Teilchen benötigt, da sich diese berühren müssen, um eine Leitfähigkeit in der Ebene zu erreichen. Bei solch einem hohen Füllgrad an elektrisch leitfähigen Teilchen leidet die Klebkraft erheblich.

Statt sphärischen Teilchen werden deshalb häufig dendritische Teilchen eingesetzt, die bei gleichem Volumen eine viel größere Oberfläche besitzen, und deshalb eine Leitfähigkeit erreicht werden kann bei geringerer Menge an elektrisch leitfähiger Teilchen. Allerdings ist die Oberfläche der Klebemassen insbesondere bei der Herstellung aus Lösung dabei sehr rau, da die einzelnen "Ärmchen" der Dendriten aus der Klebmasse herausragen, die dendritischen Teilchen können im Gegensatz zu sphärischen Teilchen nicht alle exakt die gleiche Größe besitzen. Daher ist die Laminierbarkeit der Klebemassen deutlich eingeschränkt.

Aufgabe der Erfindung war es deshalb, die Nachteile des Standes der Technik zu umgehen, und ein trägerloses in drei Dimensionen elektrisch leitfähiges Klebeband zu entwickeln für eine dauerhafte Verklebung zweier Fügeteile mit guter Laminierbarkeit und hoher Verklebungsfestigkeit.

Gelöst wird diese Aufgabe durch eine Klebstofffolie, wie sie in den Patentansprüchen näher gekennzeichnet ist.

Die Erfindung betrifft daher eine Klebefolie umfassend eine Schicht einer Klebemasse sowie der Klebemasse beigemischte leitfähige Partikeln, wobei ein Teil der leitfähigen

Partikeln faserförmig und ein Teil der Partikeln in Form dendritischer Strukturen ausgebildet ist. In bevorzugter Weise handelt es sich um eine Transfer-Klebefolie, also um eine einschichtige, trägerlose Klebefolie, die aus der Schicht der partikelhaltigen Klebemasse besteht.

Als Klebmassen werden bevorzugt vernetzbare Klebemassen eingesetzt, insbesondere solche Klebemassen, die vorzugsweise unter Wärmeeinwirkung vernetzen.

Erfindungsgemäß bevorzugt ist daher eine hitzeaktivierbare, thermovernetzende Klebstofffolie.

### Klebmassen

Die erfindungsgemäße Klebefolie umfasst eine Klebemassenmatrix, in der die erfindungsgemäß eingesetzten leitfähigen Partikeln eingemischt sind, bevorzugt in homogener Verteilung.

Als Klebemassen lassen sich beispielsweise Haftklebemassen an sich bekannter Zusammensetzung einsetzen. Erfindungsgemäß sehr vorteilhafte Klebefolien besitzen aber eine Matrix aus einer hitzeaktiviert verklebbaren Klebemasse. Hitzeaktiviert verklebbare Klebemassen (in der Literatur - wie auch im Rahmen dieser Schrift - auch als "hitzeaktivierbare Klebemasse" und "wärmeaktivierbare Klebemasse" bezeichnet) sind in der Regel bei Raumtemperatur nicht oder nur schwach selbstklebend, können aber teilweise auch schon eine deutliche Eigenklebrigkeit aufweisen. Die für die Anwendung erwünschte Klebeigenschaft wird jedoch erst nach Applikation durch Zufuhr thermischer Energie aktiviert. Durch Abkühlung wird dann die Verklebung bewirkt, so dass die erforderlichen Klebkräfte resultieren.

Als hitzeaktivierbare (Klebe-)Folien oder hitzeaktivierbare (Klebe-)Bänder werden im Rahmen dieser Schrift doppelseitige Klebefolien oder -bänder bezeichnet, bei denen die Klebmassenschicht durch eine hitzeaktiviert verklebbare Klebemasse realisiert ist. Hitzeaktivierbare Folien bzw. Bänder sind bereits vor dem Aufbringen auf das zu verklebende Substrat flächenförmig ausgestaltet und können grundsätzlich einschichtig (sogenannte Transferklebebänder) oder mehrschichtig, letzteres mit oder ohne Trägerschicht(en), ausgestaltet sein. Die erfindungsgemäßen leitfähigen Klebefolien sind einschichtig und trägerlos.

Die hitzeaktivierbaren Folien bzw. Bänder werden zur Anwendung auf das zu verklebende Substrat aufgebracht beziehungsweise zwischen die zu verklebenden Substrate eingebracht, zum Beispiel bei Raumtemperatur oder bei erhöhten Temperaturen. Nach Applikation erfolgt die Aktivierung, um die endgültige Verklebung zu bewirken.

Hitzeaktivierbare Klebmassen, wie sie auch als Matrix für das erfindungsgemäße Klebefolie geeignet sind, können grundsätzlich in zwei Kategorien unterschieden werden, nämlich in thermoplastische hitzeaktivierbare Klebemassen und in reaktive hitzeaktivierbare Klebemassen.

### a) Thermoplastische hitzeaktivierbare Klebemassen

Diese Klebemassen sind bei Raumtemperatur nicht oder schwach selbstklebend. Die Klebemasse wird erst mit der Hitze aktiviert und dabei selbstklebrig. Dafür ist ein eine entsprechend hohe Glasübergangstemperatur der Klebemasse verantwortlich, so dass die Aktivierungstemperatur zur Erzielung einer hinreichenden Klebrigkeit - in der Regel einige zig bis hundert Grad Celsius - oberhalb der Raumtemperatur liegt. Es tritt bereits vor dem Abbinden der Masse aufgrund der selbstklebenden Eigenschaften eine Klebewirkung ein. Nach dem Zusammenfügen der Klebepartner bindet die thermoplastische hitzeaktivierbare Klebemasse beim Abkühlen unter Verfestigung physikalisch (Einsatz geeigneter thermoplastischer Materialien als Klebemasse; woraus in der Regel eine reversible Verklebung resultiert), gegebenenfalls zusätzlich chemisch (Einsatz geeigneter thermoplastisch-reaktiver Materialien als Klebemasse; woraus in der Regel eine irreversible Verklebung resultiert) ab, so dass die Klebewirkung im abgekühlten Zustand erhalten bleibt und dort die eigentlichen Klebkräfte ausgebildet hat. Je mehr Wärme, Druck und/oder Zeit bei der Verklebung angewandt wird, desto fester wird in der Regel die Verbindung der beiden zu verklebenden Materialien. Hiermit können regelmäßig maximale Verbundfestigkeiten unter technisch leichten Verarbeitungsbedingungen verwirklicht werden.
Als Thermoplaste werden solche Verbindungen verstanden, wie sie im Römpp (Online Version; Ausgabe 2008, Dokumentkennung RD-20-01271) definiert sind.

### b) Reaktive hitzeaktivierbare Klebemassen

Unter dieser Bezeichnung versteht man solche Polymersysteme, die funktionelle Gruppen derart aufweisen, dass bei Wärmezufuhr eine chemische Reaktion stattfindet, wobei die Klebemasse chemisch abbindet und somit den Klebeeffekt hervorruft. Reaktive hitzeaktivierbare Klebemassen werden in der Regel bei Wärmezufuhr nicht selbstklebrig, so dass die Klebewirkung erst nach dem Abbinden eintritt. Reaktive hitzeaktivierbare Klebemassen sind häufig nicht thermoplastisch, sondern werden durch ein Elastomer-Reaktivharz-System realisiert (vergleiche aber die hitzeaktivierbaren Folien mittels thermoplastisch-reaktiver Materialien; siehe oben).
Für die Funktionalität von Reaktivsystemen ist die Glasübergangstemperatur nicht bedeutend.

Klebemassen sind grundsätzlich aufgebaut aus einem oder mehreren Polymeren (der Basispolymerkomponente, vereinfachend als Basispolymer bezeichnet), wobei zur Justierung der Eigenschaften in der Regel weitere Komponenten beigemischt sind (wie beispielweise Harze (klebrigmachenden Harze und/oder Reaktivharze), Weichmacher und dergleichen) und wobei gegebenenfalls weitere, die Eigenschaften der Klebmasse günstig beeinflussende Additive (wie beispielweise Füllstoffe oder die in der vorliegenden Erfindung relevanten leitfähigen Teilchen) zugemischt sein können.

Geeignete Elastomere, die sich als Basispolymer für die erfindungsgemäßen Klebmassen - insbesondere für reaktive hitzeaktivierbare Klebmassen - einsetzen lassen, können bevorzugt gewählt werden aus der Gruppe umfassend Polyolefine - wie beispielweise Poly-alpha-Olefine, Polyisobutylen, Polyisopren, Polybutadien oder amorphes Polypropylen -, Nitrilkautschuke, Polychloroprene, Polyethylenvinylacetate, Polyethylenvinylalkohole, Styrolbutadienkautschuke, Polyester, Polyurethane und/oder Polyamide. Besonders bevorzugt ist der Einsatz von Nitrilkautschuken.

Besonders geeignet aus der Gruppe der Polyurethane sind die thermoplastischen Polyurethane (TPU), die als Reaktonsprodukte aus Polyester- oder Polyetherolen und organischen Diisocyanaten bekannt sind. Diese Materialien können als thermoplastische und auch als thermoplastisch-reaktive hitzeaktivierbare Systeme eingesetzt werden.

Die genannnten Polymere können jeweils für sich als auch im Gemisch (mit einem oder mehreren weiteren Polymeren) eingesetzt werden.

Insbesondere für thermoplastisch-reaktive hitzeaktivierbare Klebefolien und für reaktive hitzeaktivierbare Klebefolien (also solche auf Elastomer-Basis) werden dem Basispolymer ein oder mehrere Reaktivharze zugesetzt. Der Anteil der Harze an der hitzeaktivierbaren Klebemasse beträgt bevorzugt zwischen 30 und 75 Gew.-%, bezogen auf die Masse der Mischung aus Basisolymer und Reaktivharz (ohne leitfähige Partikel-Zusätze).

Als Reaktivharz können erfindungsgemäß bevorzugt ein oder mehrere Harze unabhängig voneinander gewählt werden aus der folgenden Gruppe, umfassend die mit Spiegelstrich aufgezählten Harze:
- Epoxy-Harze; vorteilhaft solche mit einem mittleren Molekulargewicht Mw(Gewichtsmittel) von 100 g/mol bis zu maximal 10000 g/mol. Als Reaktivharze im oberen Molekulargewichts-Bereich lassen sich beispielweise polymere Epoxyharze einsetzen.
   Vorteilhaft verwendbare Epoxy-Harze umfassen zum Beispiel das Reaktionsprodukt aus Bisphenol A und Epichlorhydrin, Epichlorhydrin, Glycidyl Ester, das Reaktionsprodukt aus Epichlorhydrin und p-Amino Phenol.
   Bevorzugte kommerzielle Beispiele sind z.B. Araldite™ 6010, CY-281™, ECN™ 1273, ECN™ 1280, MY 720, RD-2 von Ciba Geigy, DER™ 331, DER™ 732, DER™ 736, DEN™ 432, DEN™ 438, DEN™ 485 von Dow Chemical, Epon™ 812, 825, 826, 828, 830, 834, 836, 871, 872,1001, 1004, 1031 etc. von Shell Chemical und HPT™ 1071, HPT™ 1079 ebenfalls von Shell Chemical.
   Beispiele für kommerzielle aliphatische Epoxy-Harze sind z.B. Vinylcyclohexandioxide, wie ERL-4206, ERL-4221, ERL 4201, ERL-4289 oder ERL-0400 von Union Carbide Corp.
- Novolak-Harze. Aus dieser Gruppe können beispielweise eingesetzt werden: Epi-Rez™ 5132 von Celanese, ESCN-001 von Sumitomo Chemical, CY-281 von Ciba Geigy, DEN™ 431, DEN™ 438, Quatrex 5010 von Dow Chemical, RE 305S von Nippon Kayaku, Epiclon™ N673 von DaiNipon Ink Chemistry oder Epicote™ 152 von Shell Chemical.
- Melamin-Harze einsetzen, wie z.B. Cymel™ 327 und 323 von Cytec.
- Terpenphenolharze einsetzen" wie z.B. NIREZ™ 2019 von Arizona Chemical.
- Phenolharze, wie z.B. YP 50 von Toto Kasei, PKHC von Union Carbide Corp. und BKR 2620 von Showa Union Gosei Corp.
- Phenolresolharze, insbesondere auch in Kombination mit anderen Phenolharzen.
- Polyisocyanate, wie z.B. Coronate™ L von Nippon Polyurethan Ind., Desmodur™ N3300 oder Mondur™ 489 von Bayer.

Zur Optimierung der klebtechnischen Eigenschaften und des Aktivierungsbereiches lassen sich der Klebmasse optional Klebkraft-steigernde Harze (sogenannte Klebharze oder Klebrigmacher) hinzusetzten. Geeignet sind unter anderem hydrierte und nicht hydrierte Derivate des Kolophoniums, Polyterpenharze, bevorzugt auf Basis von alpha-Pinen, Terpenphenolharze, nicht vernetzende Phenolharze, Novolacke, hydrierte und nicht hydrierte Polymerisate des Dicyclopentadiens, hydrierte und nichthydrierte Polymerisate von bevorzugt C-8 und C-9 Aromaten, hydrierte C-5/C9-Polymerisate, aromatenmodifizierte selektiv hydrierte Dicyclopentadienderivate, Harze auf Basis reiner Aromaten, wie z.B. alpha-Methylstyrol, Vinyltoluol oder Styrol, bzw. Harze aus Gemischen unterschiedlicher aromatischer Monomere, Cumaron-Inden-Harze, die aus dem Steinkohlenteer gewonnen werden.

Vorgenannte Klebharze können sowohl allein als auch im Gemisch zweier oder mehrerer Klebharze eingesetzt werden.

Die Klebharze werden dabei bevorzugt so gewählt, dass die Klebstofffolien bei Raumtemperatur nicht oder nur sehr wenig haftklebrig sind und ihre Klebrigkeit erst in der Hitze erhalten. Hitzeaktivierbare Folien dieser Art erhält man am besten durch die Auswahl hochschmelzender Harze, insbesondere solchen mit einem Erweichungspunkt deutlich über 110 °C (Angaben zum Erweichungspunktvon Harzen erfolgen analog der DIN EN 1427:2007 mit dem jeweiligen Harz statt Bitumen; wobei bei Erweichungstemperaturen von oberhalb 150 °C die Duchführung 8.1 b aus dieser Vorschrift analog angewandt wird). Es können auch niederschmelzendere Harze zum Einsatz kommen, die jedoch vorteilhaft nur in kleiner Menge, bevorzugt unter 30 Gew.% bezogen auf die Gesamtklebmasse ohne elektrisch leitende Partikel, eingesetzt werden.

Vorteilhaft werden vernetzbare Klebemassen für die erfindungsgemäße Klebefolie eingesetzt, besonders bevorzugt solche, die unter Wärmeeinwirkung vernetzen.

Zum Zwecke der Vernetzung ist es möglich, der Klebmasse insbesondere chemische Vernetzer (auch als Härter bezeichnet) zuzusetzen, besonders solche, die mit zumindest einem der Reaktivharze reagieren können. Vernetzer sind für die Reaktion nicht nötig, können aber besonders, um einen Überschuss an Reaktivharz abzufangen, zugegeben werden. Insbesondere bei der Verwendung von Epoxidharzen als Reaktivharz haben sich Vernetzer als vorteilhaft herausgestellt.

Als Vernetzer beziehungsweise Härter kommen hauptsächlich folgende Verbindungen zum Einsatz, wie sie beispielsweise in der US 3,970,608 A näher beschrieben sind:
- Mehrwertige aliphatische Amine wie zum Beispiel Triethylentetramin
- Mehrwertige aromatische Amine wie zum Beispiel Isophorondiamin
- Guanidine wie zum Beispiel Dicyandiamid
- Mehrwertige Phenole
- Mehrwertige Alkohole
- Mehrwertige Mercaptane
- Mehrwertige Carbonsäuren
- Säureanhydride mit einer oder mehreren Anhydridgruppen

Um die Reaktionsgeschwindigkeit der Vernetzungsreaktion zu erhöhen, ist der Einsatz von so genannten Beschleunigern möglich.

Beschleuniger können zum Beispiel sein:
- tertiäre Amine wie Benzyldimethylamin, Dimethylaminomethylphenol,
- Tris( dimethylaminomethyl)phenol
- Bortrihalogenid-Amin-Komplexe
- substituierte Imidazole
- Triphenylphosphin.

Bei der Verwendung von Phenolharzen (dabei insbesondere Alkylphenolharzen) können Formaldehydspender zugesetzt werden, wie z.B. Hexamethylentetramin.

Zur Abstimmung der gewünschten Eigenschaften der - insbesondere hitzeaktivierbaren - Klebemasse können optional Füllstoffe (z.B. (insbesondere nichtleitende) Fasern, Ruß, Zinkoxid, Titandioxid, Kreide, Voll- oder Hohlglaskugeln, Mikrokugeln aus anderen Materialien, Kieselsäure, Silikate), Keimbildner, Blähmittel, klebverstärkende Additive und Thermoplaste, Compoundierungsmittel und/oder Alterungsschutzmittel, z.B. in Form von primären und sekundären Antioxidantien oder in Form von Lichtschutzmitteln zugesetzt sein.

Als weitere Additive können typischerweise genutzt werden: primäre Antioxidantien, wie z. B. sterisch gehinderte Phenole, sekundäre Antioxidantien, wie z. B. Phosphite oder Thioether, Prozessstabilisatoren, wie z. B. C-Radikalfänger, Lichtschutzmittel, wie z. B. UV-Absorber oder sterisch gehinderte Amine, Antiozonantien, Metalldesaktivatoren, sowie Verarbeitungshilfsmittel, um nur einige wenige zu nennen.

Es hat sich gezeigt, dass durch den Einsatz eines Gemisches von dendritischen Metallpartikeln und leitfähigen faserförmigen Partikeln deutliche Vorteile erhalten werden im Gegensatz zum Einsatz nur einer dieser beiden Partikelformen.
Beim reinen Einsatz von dendritischen Teilchen ist die Oberfläche des Klebebandes sehr rau, ein großer Teil der Partikel steht aus der Klebmasse hervor und verhindert ein gutes Auffließen.
Faserförmige Partikel richten sich bei der Herstellung des Klebebandes aus Lösung aus und sind bevorzugt in Bahnrichtung orientiert. Die Leitfähigkeit in dieser Richtung ist daher sehr viel höher als rechtwinklig dazu. Zudem ist die Leitfähigkeit in z-Richtung deutlich geringer als bei Verwendung dendritischer Partikeln.

Überraschenderweise konnte nun gefunden werden, dass bei einer Mischung dieser Teilchen, eine deutlich bessere Performance erreicht werden kann als bei Verwendung nur einer der Partikelsorten (faserförmig oder dendritisch), selbst wenn die Gesamtmenge an leitfähigen Partikeln nicht erhöht wird. Zum einen ist die Leitfähigkeit in z-Richtung immer noch extrem gut, diese ändert sich nicht, verglichen mit der verwednung rein dendritischer Partikeln. Die Leitfähigkeit in x,y-Richtung ist immer noch so gut wie bei dem Einsatz reiner Fasern, auch der Unterschied zwischen der Bahnrichtung und der dazu rechtwinkligen Richtung ist nur noch sehr gering. Durch den geringeren Anteil an Dendriten ist die Klebmasse jetzt allerdings deutlich besser laminierbar und deutlich klebstärker.
Der Gesamtgehalt an Teilchen kann sogar etwas gesenkt werden, ohne dass die Leitfähigkeit in x-Richtung signifikant erniedrigt wird.

Eine Sorte der leitfähigen Partikeln, die der erfindungsgemäßen Klebefolie zugesetzt sind, sind solche Partikeln, deren Struktur eine anisotrope, mehrfach verzweigte Morphologie derart aufweist, dass von einem Stamm (primärer Arm) kleinere Seitenverzweigungen (sekundäre Arme) ausgehen, die ihrerseits wieder Seitenverzweigungen (tertiäre Arme) aufweisen können. Die Verzweigungen können dabei gerade oder gebogen sein und können jeweils wiederum verzweigt sein, ähnlich der Struktur eines Tannenbaumes. Derartige Partikeln werden in der Literatur - wie auch im Rahmen dieser Schrift - als "Dendriten", als "dendritische Partikeln", als "Partikeln mit dendritischer Form" und als "Partikeln mit dendritischer Struktur" bezeichnet. Üblicherweise ist die Ausdehnung in einer Dimension größer als in zumindest einer anderen Dimension, insbesondere als in beiden anderen Dimensionen.
Als dendritische Partikeln werden erfindungsgemäß solche Partikeln eingesetzt, die zumindest sekundäre Arme aufweisen, bevorzugt solche, die zumindest auch tertiäre Arme besitzen.

Als dendritische Partikeln können bevorzugt solche Teilchen aus Metall eingesetzt werden, z.B. aus Zink, Eisen, Bismut, Kupfer, Silber oder Gold, um nur einige wenige zu benennen. Je nach Umgebungsbedingungen wird das Metall der Teilchen so ausgewählt, dass die Teilchen nicht nach kurzer Zeit durch Oxidation versagen. Bevorzugt werden Kupfer- oder Silberdendriten verwendet. Gold lässt sich ebenfalls hervorragend einsetzen, ist aber sehr teuer. Um die hohe Leitfähigkeit und gute Oxidationsbeständigkeit des Silbers zu nutzen, ohne dabei zu hohe Kosten zu haben, werden bevorzugt versilberte Kupferdendriten eingesetzt, wobei bevorzugt das Kupfer vollständig durch die Silberschicht bedeckt ist. Je nach der Größe der Partikel werden unterschiedliche Mengen an Silber eingesetzt werden, um das Kupfer vollständig zu bedecken. Bei Partikeln zwischen 30 und 40µm sind es etwa 20% Silber.

Die durchschnittliche Größe der Dendriten wird bevorzugt derart gewählt, dass ihre maximale Ausdehnung in etwa der Dicke der Klebfolie entspricht. Sehr bevorzugt werden daher dendritische Teilchen mit einer mittleren maximalen Ausdehnung im Bereich von 20 bis 100 µm, bevorzugt im Bereich von 40 bis 80 µm.

Die zweite Sorte der leitfähigen Partikeln, die der erfindungsgemäßen Klebefolie zugesetzt sind, haben eine faserförmige Struktur. Faserförmige Teilchen haben eine Ausdehnung in einer Vorzugsrichtung, die deutlich größer ist als in jede senkrecht auf der Vorzugsrichtung stehende Ausdehnung. Sehr bevorzugt werden als Fasern solche Partikeln eingesetzt, deren maximale Ausdehnung mindestens dreimal so groß ist wie die größte Ausdehnung senkrecht zu der Richtung der Maximalausdehnung.
Die Größe der Fasern sollte dabei klein gewählt werden und die Länge der Fasern (maximale Ausdehnung der Faserpartikeln) sollte nicht größer sein als das Zehnfache der Dicke der Klebmasseschicht. Bevorzugt werden Teilchen mit einer Länge nicht größer als der 5fachen Dicke der Klebmasseschicht eingesetzt, besonders bevorzugt solche von maximal der doppelten Länge bezogen auf die Dicke der Klebmasseschicht, ganz besonders bevorzugt von der 1,5fachen Länge der Dicke der Klebmasseschicht. Je kürzer die Fasern sind, desto besser ist die Beschichtbarkeit der Klebmasselösung.

Die faserförmigen Teilchen können entweder direkt aus Metall bestehen oder es werden vorzugsweise metallisierte Fasern, insbesondere metallisierte Glasfasern, eingesetzt. Auch metallisierte Kohlenstofffasern sind geeignet. Die Metallschicht bedeckt dabei bevorzugt zumindest den überwiegenden Teil der Oberfläche des inneren Materials, sehr bevorzugt die vollständige Oberfläche des inneren Materials.

Idealerweise benutzt man faserförmige Teilchen, die außen (also an zumindest dem überwiegenden Teil ihrer Oberfläche) dasselbe Metall enthalten wie die Dendriten an zumindest dem überwiegenden Teil der Oberfläche, damit kein elektrisches Lokalelement entsteht und eventuell ein Metall abgebaut werden könnte.

Bevorzugt werden versilberte Kupferdendriten im Gemisch mit versilberten Glasfasern eingesetzt.

Das Verhältnis von Dendriten zu Fasern kann schwanken, keine der beiden Partikelarten sollte aber in mehr als einem zehnfachen Überschuss, bezogen auf das Gesamtgewicht der leitfähigen Teilchen, vorliegen. Sehr vorteilhaft werden Fasern und Dendriten in gleichen Gewichtsanteilen eingesetzt.

Der Anteil der leitfähigen Teilchen (Dendriten und Fasern gemeinsam) liegt zwischen 40 und 90 Gew.-%, bezogen auf die Gesamtmasse der Klebmasse inklusive Partikeln, bevorzugt liegt der Gehalt zwischen 50 und 80 Gew.-%, besonders bevorzugt zwischen 55 und 70 Gew.-%.

Die erfindungsgemäße Klebefolie kann hervorragend eingesetzt werden für Verklebungen im elektronischen Bereich, zum Beispiel zum Verkleben elektronischer Leiterbahnen.

Die erfindungsgemäßen Klebefolien weisen sehr bevorzugt Dicken im Bereich von 30 bis 100 µm, bevorzugt von 40 bis 50 µm auf.

Experimenteller Teil:

### Verklebung von FCCL's mit dem hergestellten Klebeband

Ein FCCL (Flexible Copper Clad Laminate) PyraluxLF9110R (1oz Cu/) + (25µm Adhesive) + (25µm Kapton) wird jeweils mit den nach den Beispielen hergestellten Klebebändern auf einen Stiffener aus Stahl geklebt. Dazu wird das Klebeband in einer Breite von 1,5cm auf die Polyimidfolie des FCCL-Laminats aus Polyimid/Kupferfolie bei 100 °C auflaminiert, wobei der Klebestreifen etwas kürzer als das zu verklebende FCCL ist, um später einen Anfasser zu haben. Anschließend wird dieser Verbund aus FCCL und Klebeband auf einen Stiffener aus Stahl laminiert bei 100°C, und der ganze Verbund in einer beheizbaren Bürklepresse bei 180 °C bei einem Druck von 1,3 MPa für 20min verpresst.

### L-Peel Test mit FCCL-Stiffener-Verbund [IPC-TM-650 Nr. 2.4.9]

Mit einer Zugprüfmaschine der Firma Zwick wird das FCCL der nach dem oben beschriebenen Verfahren hergestellten Verbunde aus FCCL und Stahl im 90° Winkel von dem Stiffener mit einer Geschwindigkeit von 50 mm/min abgezogen und die benötigte Kraft in N/cm gemessen.

### Elektrischer Widerstand

Die Messungen erfolgen in Anlehnung an den militärischen Standard MIL-DTL- 83528C.

### Elektrischer Widerstand in z-Richtung

Eine Probe der Klebefolie wird von ggf. vorhandenen Trennfolien oder -papieren befreit und ein 5 x 5cm² großes Stück ausgeschnitten. Dieses Stück wird dann zwischen zwei zylinderförmige, vergoldete, vorher mit Ethanol gereinigte Elektroden mit jeweils einer runden Kontaktfläche von 1 inch² (jeweils eine Stirnseite der jeweiligen zylinderförmigen Elektrode) gebracht, die mit einer Strom-Spannungs-Quelle und einem empfindlichen Ohmmeter verbunden sind. Die Klebefolie ist dann horizontal zwischen den jeweils ebenfalls horizontalen Kontaktflächen ausgerichtet. Die untere der Elektroden liegt mit ihrer der Klebefolie entfernt liegenden Stirnseite auf einer festen Oberfläche auf. Anschließend wird ein 5 kg-Gewicht auf die der Klebefolie entfernt liegende Stirnseite der oberen Elektrode gestellt, um die Kontaktierung der Klebefolie zu optimieren. Die Messung erfolgt bei 23 °C und 50 % rF. Gemessen wid der Widerstand in Ohm.

### Elektrischer Wiederstand in x,y-Richtung (Oberflächenwiderstand)

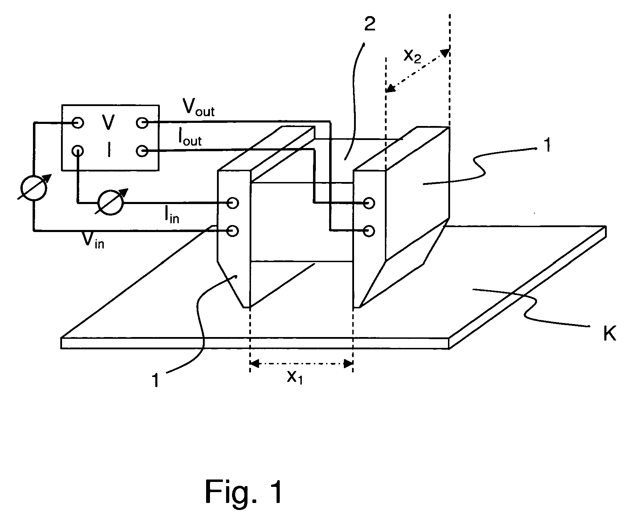

Eine Probe der unvernetzten Klebefolie wird von ggf. vorhandenen Trennfolien oder - papieren befreit und ein 5 x 5 cm² großes Stück ausgeschnitten. Es wird eine Messanordnung verwendet, wie sie in Fig. 1 dargestellt ist. Dabei bedeuten:
- V: Spannungsquelle
- I: Stromquelle
- K: Klebfolienprobe
- 1: vergoldete Elektroden
- 2: Isolator
- x₁, x₂: Länge und Breite der Elektrodenzwischenfläche, jeweils 1 inch

Die Elektrode wird nach Reinigung mit Ethanol auf die Probe gestellt. Die Fläche zwischen den beiden Teilen der Elektrode beträgt genau 1 inch², 6,45mm². Wieder erfolgt die Messung bei 23 °C und 50 % rF. Das Gewicht desElektrodenaufbaus Elektroden und Isolator) beträgt 240 g.
Der gemessene Wert wird in Ohm angegeben.
Zur Unterscheidung einer Vorzugsrichtung wird die Probe einmal in x-Richtung, das ist die Richtung in der beschichtet wurde und einmal in y-Richtung, quer zur Beschichtungsrichtung, gemessen.

### Beispiele

### Beispiel 1:

Es wurde eine Suspension von 66,5 Gew.-% Breon N41H80 (Nitrilkautschuk der Fa. Zeon mit 41 % Acrylnitril), 33 Gew.-% Epiclon 660 (Novolak-Harz der Fa. DIC) und 0,5 Gew.% 2-Phenylimidazol (bezogen auf Feststoff; eingesetzt 30 %ig in Butanon) in einem Kneter hergestellt. Die Knetdauer betrug 20 h.

Anschließend wurden zu der Suspension pro 30 Teile (jeweils bezogen auf das Gewicht) feste Klebmassebestandteile 35 Teile dendritische versilberte Kupferpartikel der Fa. Potters (SC25D20S) und 35 Teile versilberte Glasfasern mit einer maximalen Länge von 40 µm der Fa. Nanotechnologies (STAR SHIELD AG 5512 FI) zugegeben.

Die hitzeaktivierbare Masse wurde anschließend auf eine silikonisierte PET-Folie ausgestrichen und bei 100 °C getrocknet, so dass eine 40 µm dicke Klebstoffschicht entstand.

### Vergleichsbeispiel 2:

Statt des Gemisches aus Fasern und Dendriten wurden 70 Teile Dendriten zugegeben.

### Vergleichsbeispiel 3:

Statt des Gemisches aus Fasern und Dendriten wurden 70 Teile Fasern zugegeben.

**Ergebnisse:**

| | L-Peel-Test In N/cm | Leitfähigkeit in z-Richtung in ohm | Leitfähigkeit in x-Richtung in ohm | Leitfähigkeit in y-Richtung in ohm |
|---|---|---|---|---|
| Beispiel 1 | 8,2 | 0,0005 | 0,14 | 0,21 |
| Vergleichsbeispiel 2 | 5,7 | 0,0004 | 0,16 | 0,17 |
| Vergleichsbeispiel 3 | 8,5 | 2,4 | 0,09 | 0,52 |

Auffällig ist bei dem Vergleichsbeispiel 2, dass sich dieses nur sehr schlecht auf das FCCL laminieren lässt. Dieses ist bei dem Beispiel 1 sehr viel einfacher möglich. Trotzdem hat man eine ähnlich gute Leitfähigkeit im Gegensatz zum Beispiel 3.

### Beispiel 4:

Es wurde eine Suspension von 66,5 Gew.% Breon N41H80 (Nitrilkautschuk der Fa. Zeon mit 41 % Acrylnitril), 33 Gew.-% Epiclon 660 (Novolak-Harz der Fa. DIC) und 0,5 Gew.-% 2-Phenylimidazol (bezogen auf Feststoff; eingesetzt 30 %ig in Butanon) in einem Kneter hergestellt. Die Knetdauer betrug 20h.

Anschließend wurden zu der Suspension pro 40 Teile feste Klebmassebestandteile 30 Teile dendritische versilberte Kupferpartikel der Fa. Potters (SC25D20S) und 30 Teile versilberte Glasfasern mit einer maximalen Länge von 40 µm der Fa. Nanotechnologies (STAR SHIELD AG 5512 FI) zugegeben.

Die hitzeaktivierbare Masse wurde anschließend auf eine silikonisierte Per-Folien ausgestrichen und bei 100 °C getrocknet, so dass eine 40 µm dicke Klebstoffschicht entstand.

### Vergleichsbeispiel 5:

Statt des Gemisches aus Fasern und Dendriten wurden 60 Teile Dendriten zugegeben.

### Vergleichsbeispiel 6:

Statt des Gemisches aus Fasern und Dendriten wurden 60 Teile Fasern zugegeben.

**Ergebnisse:**

| | L-Peel-Test In N/cm | Leitfähigkeit in z-Richtung in ohm | Leitfähigkeit in x-Richtung in ohm | Leitfähigkeit in y-Richtung in ohm |
|---|---|---|---|---|
| Beispiel 4 | 10,4 | 0,0006 | 0,30 | 0,43 |
| Vergleichsbeispiel 5 | 8,3 | 0,0006 | >10 | >10 |
| Vergleichsbeispiel 6 | 10,8 | >10 | 0,23 | 1,44 |

Insbesondere beim Einsatz geringerer Anteile an Partikeln kann man erkennen, dass eine Mischung aus Dendriten und Fasern sehr vorteilhaft ist, da nur mit einer Kombination noch hohe Leitfähigkeiten bzw. geringe elektrische Widerstände in allen drei Richtungen erzielt werden können.

## Patentansprüche

1. Klebefolie umfassend eine Schicht einer Klebemasse sowie der Klebemasse beigemischte leitfähige Partikeln, **dadurch gekennzeichnet, dass**
ein Teil der leitfähigen Partikeln faserförmig und ein Teil der Partikeln in Form dendritischer Strukturen ausgebildet ist.

2. Klebefolie nach Anspruch 1, **dadurch gekennzeichnet, dass**
als Klebemasse eine hitzeaktiviert verklebbare Klebemasse eingesetzt wird.

3. Klebefolie nach einem der vorangehenden Ansprüche, **dadurch gekennzeichnet, dass**
als faserförmige leitfähige Partikeln Metallfasern und/oder metallisierte Fasern eingesetzt werden.

4. Klebefolie nach einem der vorangehenden Ansprüche, **dadurch gekennzeichnet, dass**
als dendritische leitfähige Partikeln Metallpartikeln und/oder metallisierte Partikeln eingesetzt werden.

5. Klebefolie nach einem der vorangehenden Ansprüche, **dadurch gekennzeichnet, dass** die Oberfläche der faserförmigen leitfähigen Partikeln und die Oberfläche der dendritischen leitfähigen Partikeln aus demselben Material bestehen.

6. Klebefolie nach einem der vorangehenden Ansprüche, **dadurch gekennzeichnet, dass**
als dendritische leitfähige Partikeln versilberte Kupferpartikeln und als faserförmige leitfähige Partikeln versilberte Glasfasern eingesetzt werden.

7. Klebefolie nach einem der vorangehenden Ansprüche, **dadurch gekennzeichnet, dass**
die maximale Länge der faserförmigen leitfähigen Partikeln nicht größer ist als das Zehnfache der Dicke der Klebefolie, bevorzugt nicht größer als das Fünffache der Dicke der Klebefolie, besonders bevorzugt nicht größer als das Anderthalbfache der Dicke der Klebefolie.

8. Klebefolie nach einem der vorangehenden Ansprüche, **dadurch gekennzeichnet, dass**
der Gesamtanteil der leitfähigen Teilchen an der Klebefolie 40 bis 90 Gew.-% beträgt.

9. Klebefolie nach einem der vorangehenden Ansprüche, **dadurch gekennzeichnet, dass**
das Gewichtsverhältnis V der faserförmigen leitfähigen Partikeln zu den dendritischen leitfähigen Partikeln im Bereich von 10 : 1 bis 1 : 10 liegt; bevorzugt 1:1 beträgt.

## Claims

1. Adhesive sheet comprising a layer of an adhesive and also conductive particles admixed to the adhesive, **characterized in that** some of the conductive particles are fibriform and some of the particles are in the form of dendritic structures.

2. Adhesive sheet according to Claim 1, **characterized in that** the adhesive used is a heat-activatedly bondable adhesive.

3. Adhesive sheet according to either of the preceding claims, **characterized in that** fibriform conductive particles used are metal fibers and/or metallized fibers.

4. Adhesive sheet according to any of the preceding claims, **characterized in that** dendritic conductive particles used are metal particles and/or metallized particles.

5. Adhesive sheet according to any of the preceding claims, **characterized in that** the surface of the fibriform conductive particles and the surface of the dendritic conductive particles consist of the same material.

6. Adhesive sheet according to any of the preceding claims, **characterized in that** dendritic conductive particles used are silverized copper particles, and fibriform conductive particles used are silverized glass fibers.

7. Adhesive sheet according to any of the preceding claims, **characterized in that** the maximum length of the fibriform conductive particles is not greater than ten times the thickness of the adhesive sheet, preferably not greater than five times the thickness of the adhesive sheet, more preferably not greater than one and a half times the thickness of the adhesive sheet.

8. Adhesive sheet according to any of the preceding claims, **characterized in that** the total fraction of the conductive particles in the adhesive sheet is 40 to 90 wt%.

9. Adhesive sheet according to any of the preceding claims, **characterized in that** the weight ratio V of the fibriform conductive particles to the dendritic conductive particles is in the range from 10:1 to 1:10, and preferably is 1:1.

## Revendications

1. Feuille adhésive comprenant une couche d'une masse adhésive, ainsi que des particules conductrices mélangées à la masse adhésive, **caractérisée en ce qu'**une partie des particules conductrices sont fibreuses, et une partie des particules sont configurées sous forme de structures dendritiques.

2. Feuille adhésive selon la revendication 1, **caractérisée en ce qu'**on utilise en tant que masse adhésive une masse adhésive pouvant être collée, activée à la chaleur.

3. Feuille adhésive selon l'une des revendications précédentes, **caractérisée en ce qu'**on utilise en tant que particules conductrices fibreuses des fibres métalliques et/ou des fibres métallisées.

4. Feuille adhésive selon l'une des revendications précédentes, **caractérisée en ce qu'**on utilise en tant que particules conductrices dendritiques des particules métalliques et/ou des particules métallisées.

5. Feuille adhésive selon l'une des revendications précédentes, **caractérisée en ce que** la surface des particules conductrices fibreuses et la surface des particules conductrices dendritiques sont constituées du même matériau.

6. Feuille adhésive selon l'une des revendications précédentes, **caractérisée en ce qu'**on utilise en tant que particules conductrices dendritiques des particules de cuivre argentées, et en tant que particules conductrices fibreuses des fibres de verre argentées.

7. Feuille adhésive selon l'une des revendications précédentes, **caractérisée en ce que** la longueur maximale des particules conductrices fibreuses n'est pas supérieure à dix fois l'épaisseur de la feuille adhésive, de préférence n'est pas supérieure à cinq fois l'épaisseur de la feuille adhésive, d'une manière particulièrement préférée n'est pas supérieure à une fois et demie l'épaisseur de la feuille adhésive.

8. Feuille adhésive selon l'une des revendications précédentes, **caractérisée en ce que** la proportion totale des particules conductrices, par rapport à la feuille adhésive, est de 40 à 90 % en poids.

9. Feuille adhésive selon l'une des revendications précédentes, **caractérisée en ce que** le rapport en poids V des particules conductrices fibreuses aux particules conductrices dendritiques est compris dans la plage de 10:1 à 1:10, et est de préférence de 1:1.
